# EUROPÄISCHE PATENTANMELDUNG

(11) **EP 1 406 365 A1**
(43) Veröffentlichungstag der Anmeldung: **07.04.2004**
(21) Anmeldenummer: 02022465.5
(22) Anmeldetag: 04.10.2002
(51) Int. Cl.: H02H 1/00, G01R 19/00, G01R 31/34, H02K 13/00, H02K 13/10

(54) **Erregerstromzuführung für eine elektrische Rotationsmaschine**

(71) Anmelder: SIEMENS AKTIENGESELLSCHAFT, 80333 München (DE)
(72) Erfinder: Klaar, Juergen, 47506 Neukirchen-Vluyn (DE)

(57) **Zusammenfassung**

Die Erfindung betrifft eine elektrische Erregerstromzuführung für eine elektrische Rotationsmaschine mit einer Mess- und Auswerteeinrichtung, die entlang eines Schleifringes eine Antenne und ein Mikrofon aufweist zur Überwachung eines Schleifringes, der in Kontakt mit Kohlebürsten steht, um die Schleifringe kontrollieren zu können.

## Beschreibung

Die Erfindung betrifft eine Erregerstromzuführung für eine elektrische Rotationsmaschine mit einer Mess- und Auswerteeinheit, die einen Abstandssensor zur Überwachung eines Schleifringes aufweist, der in Kontakt mit Kohlebürsten steht.

Elektrische Rotationsmaschinen weisen eine Feldwicklung auf einem Läufer auf. Eine solche Ausführungsform ist in DE 196 19 728 A1 beschrieben. Ein Erregerstrom der Feldwicklung wird über Schleifringe und Kohlebürsten zugeführt. Die Höhe des Erregerstroms ist bei Generatoren, die zur Energieversorgung dienen, von der benötigten Leistung abhängig. Für eine möglichst gute Übertragung des Erregerstroms durch die Kohlebürsten ist eine bestimmte spezifische Strombelastung der Bürsten erforderlich. Die Zuführung des Stroms erfolgt über rotierende Schleifringe und feststehende Kohlebürsten, die die Schleifringe kontaktieren. Während des Kontaktes schleifen die Bürsten an den entsprechenden rotationssymmetrischen Flächen der Schleifringe. Hierdurch bedingt unterliegen die rotierenden Schleifringe und insbesondere die Bürsten einem hohen Verschleiß.

Die Bürsten sind häufig in sogenannten Steckbürstenhalterungen angeordnet, die ihrerseits in stationären Ringen gehaltert werden. Die Steckbürstenhalterungen und die Ringe sind so ausgestaltet, dass die Steckbürstenhalterungen relativ leicht vom Halter entfernt werden können. Die in der Steckbürstenhalterung angeordnete Bürste, insbesondere Kohlebürste, muss ausgetauscht werden, wenn die Bürste ihre minimal zulässige Länge erreicht hat.

Wegen des hohen Verschleißes und da zudem die Standzeiten der einzelnen Kohlebürsten sehr unterschiedlich sind, muss der Abrieb der Kohlebürsten im Rahmen von Wartungsarbeiten in relativ kurzen Zeitabständen überprüft werden. Derartige Wartungsarbeiten erfolgen während des Betriebs bei Betriebsspannung. Die Wartungsarbeiten sind auf Grund des Gefährdungspotentials nur durch entsprechend geschultes Fachpersonal durchzuführen. Zudem sind sie sehr zeitaufwendig, da beispielsweise bei einem Turbosatz mit 6000 Ampere Erregerstrom etwa 120 Kohlebürsten gewartet werden müssen.

Allgemein ist das System zwischen Kohlebürsten und Schleifringen bzw. Kommutatoren - neben dem normalen Verschleiß - auch sehr störanfällig und muss daher zusätzlich überwacht werden. Störgrößen sind ein zu hoher Verschleiß, eine zu hohe Temperatur, ein sogenanntes Bürstenfeuer, d.h. Glimmentladungen zwischen Bürsten und Schleifring und damit verbunden sogenannte Brandflecken, unzulässige Schwingungen und Rattern, ein Ausbrechen der Bürsten usw..

Die Überwachung und Begutachtung der Schleifringe erfolgt zum heutigen Zeitpunkt oft noch durch optische Kontrolle in frei wählbaren Zeitabständen, die aus Erfahrungswerten des Fachpersonals resultieren.

In modernen Ausführungen des Bürstenträgerapparates ist eine direkte Beobachtung der Schleifringoberfläche häufig nicht mehr möglich. Die Gefahr einer Nichterkennung von Störungen erhöht sich dadurch und könnte zu einem Ausfall mit Folgeschäden führen.

Der vorliegenden Erfindung liegt deshalb die Aufgabe zugrunde, eine Erregerstromzuführung für eine elektrische Rotationsmaschine anzugeben, die eine Mess- und Auswerteeinrichtung zur Kontrolle des Schleifrings vorsieht.

Erfindungsgemäß wird diese Aufgabe durch eine Mess- und Auswerteeinrichtung, die entlang des Schleifrings Antennen und Mikrofone aufweist, gelöst. Durch Bürstenfeuer entstehende Lichtbögen, die hochfrequente elektromagnetische Wellen hervorrufen, werden durch die Installation einer im Bereich des Bürstenträgers angeordneten Antenne empfangen und mit einer nachgeschalteten Auswerteeinrichtung analysiert. Durch Bürstenfeuer können mechanische Störungen auf dem Schleifring entstehen. Zur Überwachung der mechanischen Störungen wird ein Richtmikrofon in unmittelbarer Nähe der Bürstenträger installiert, welcher durch Brandflecken hervorgerufene akustische Signale aufnimmt. Die aufgenommenen Informationen werden ebenfalls zu der nachfolgend geschalteten Auswerteeinheit übertragen und analysiert.

Durch die Mess- und Auswerteeinrichtung ist eine zeitnahe und genaue Überprüfung der Schleifringe möglich. Eine Begehung des Fachpersonals, zur Überprüfung der Qualität der Schleifringe kann reduziert werden. Ein weiterer Vorteil ist, dass die aufgenommenen Informationen von der Antenne und dem Mikrofon auf Datenträger 29 gespeichert werden können. Damit ist es insbesondere möglich, Störungsfälle im nachhinein zu analysieren. Auch die frühzeitige Erkennung von sich anbahnenden Störungen ist dadurch möglich.

In vorteilhafter Weiterbildung wird ein Taktgeber auf den Schleifring angebracht. Dieser liefert ein Triggersignal, durch den es möglich ist, Schäden auf dem Schleifring auch genau zu lokalisieren.

Vorzugsweise ist weiterhin vorgesehen, dass während eines belastungsfreien Betriebes der elektrischen Rotationsmaschine Messergebnisse einer Messung mit der Antenne und den Mikrofonen in einem Datenträger 29 gespeichert werden, um diese mit Messergebnissen einer Messung, die während eines belasteten Betriebes der elektrischen Rotationsmaschine aufgenommen werden, zu vergleichen.

Die Abnutzung der Schleifringe und der Kohlebürsten ist von der Polarität der Erregerstromzuführung abhängig. Dies hängt mit der Diffusion von einzelnen Ionen des Schleifrings in die Kohlebürste bzw. von der Kohlebürste in den Schleifring zusammen. In vorteilhafter Ausgestaltung werden deswegen je eine Mess- und Auswerteeinrichtung für einen elektrisch positiven Schleifring und einen elektrisch negativen Schleifring installiert. Die Abnutzung und Beobachtung der Qualität des Schleifringes kann somit individuell, sowohl für den elektrisch positiven als auch für den elektrisch negativen Schleifring erfolgen.

Vorzugsweise wird die Antenne in mehrere Antenneneinheiten entlang des Schleifrings unterteilt. Dadurch ist eine exakte Lokalisierung von Schäden auf den Schleifringen möglich, da eine Antenneneinheit ein bestimmtes Kreissegment überdeckt.

Die auf das Verfahren gerichtete Aufgabe wird dadurch gelöst, dass elektromagnetische Wellen, die durch Bürstenfeuer entstehen, von einer Antenne erfasst werden und Geräusche, die durch Bürstenfeuer entstandene Schäden auf dem Schleifring hervorrufen, mit Mikrofonen erfasst werden, wobei die so erfassten Informationen mit einer Auswerteeinrichtung analysiert werden.

Im folgenden wird die Erfindung anhand von Ausführungsbeispielen näher erläutert, die in schematischer Weise in der Zeichnung dargestellt ist.

Für gleiche und funktionsidentische Bauteile werden durchgehend dieselben Bezugszeichen verwendet.

Es zeigen:
FIG. 1 einen Ausschnitt eines Turbogenerators;
FIG. 2 einen schematischen Längsschnitt durch den Schleifring einer elektrischen Rotationsmaschine;
FIG. 3 einen axialen Längsschnitt durch den Schleifring einer elektrischen Rotationsmaschine;
FIG. 4 ein vereinfachtes Blockschaltbild der Auswerteeinrichtung

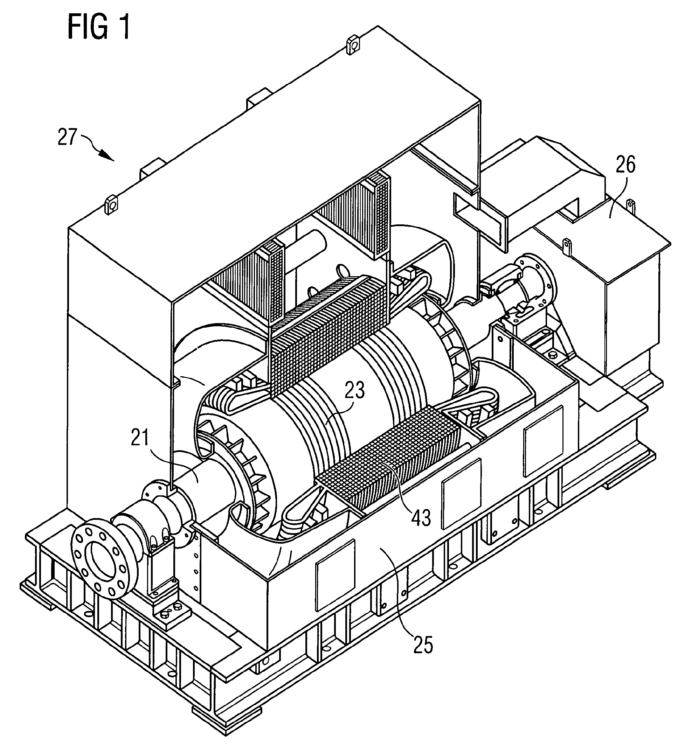

FIG 1. Zeigt einen Turbogenerator 27 der eine auf einer Welle befindliche Läuferwicklung 23 und eine am Gehäuse 25 befestigte Statorwicklung 24 aufweist. Die für die Einspeisung eines Erregerstromes zuständige Erregerstromzuführung 1 befindet sich hinter der Abdeckung 26.

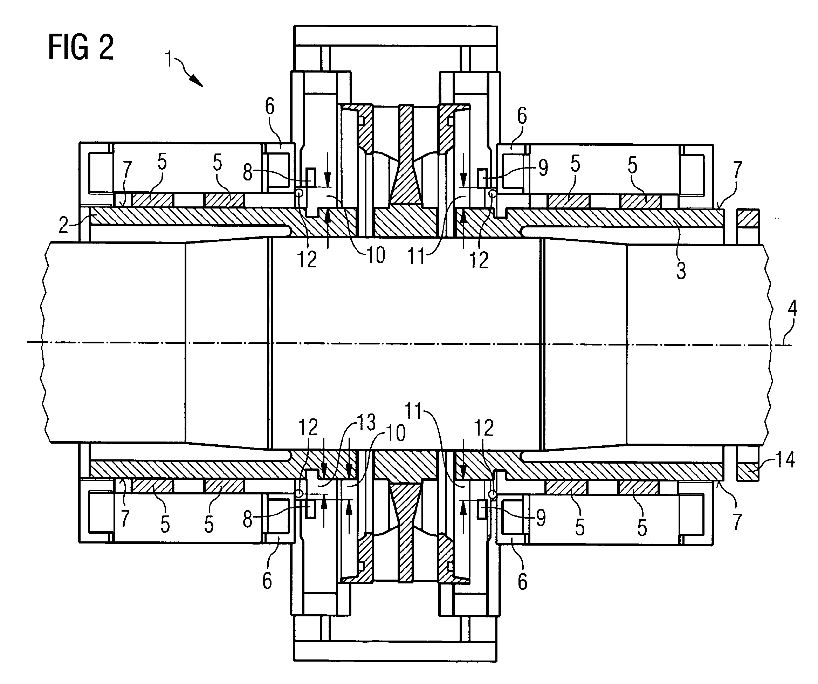

FIG. 2 zeigt einen Längsschnitt durch eine Erregerstromzuführung 1 einer nicht näher dargestellten elektrischen Rotationsmaschine 1. Die elektrische Rotationsmaschine 1 weist einen elektrisch negativen Schleifring 2 und elektrisch positiven Schleifring 3 auf. Die Schleifringe 2 und 3 bestehen aus einem elektrisch leitenden Material und sind um eine Rotationsachse 4 auf einer Welle 21 drehgelagert. In Bürstenhalterungen 6 sind mehrere Bürsten 5 insbesondere Kohlebürsten 5 verschieblich gehaltert. Die Kohlebürsten 5 sind radial zur Drehachse 4 verschieblich. Die Oberfläche des Schleifrings 2 oder 3 steht in elektrischem Kontakt mit einer Kohlebürste 5. Sowohl am elektrisch positiven Schleifring 2 als auch am elektrisch negativen Schleifring 3 ist jeweils eine Antenne 8 und 9 rotationssymmetrisch zur Drehachse 4 um die beiden elektrischen Schleifringe 2, 3 angebracht. Der Abstand 10, 11 zwischen jeder der Antennen 8, 9 und dem jeweiligen Schleifring 2, 3 ist auf dem gesamten Umfang des Schleifringes 2, 3 gleich. In der Nähe der Bürstenhalter 6 ist ein Mikrofon 12 angebracht.

Auf der Schleifringoberfläche 7 ist ein Taktgeber 14 angebracht, der ein Triggersignal für eine Mess- und Auswerteeinrichtung liefert. Dadurch können Störungen auf dem Schleifring 2, 3 lokalisiert werden.

Die Antennen 8 und 9 sind an den jeweiligen Schleifringen in einzelne Einheiten unterteilt, damit Störungen auf dem Schleifring lokalisiert werden können.

Eine Störung auf dem Schleifring 2, 3 kann zu einem Bürstenfeuer führen. Das Bürstenfeuer entsteht an den Stellen, an denen ein Kontakt zwischen der Kohlebürste 5 und dem Schleifring 2, 3 besteht. Durch das Bürstenfeuer wird ein Signal in einer Antenneneinheit erzeugt. In der Antenneneinheit, das der Störung am nächsten liegt, entsteht das größte Signal. Gemeinsam mit einem Taktgeber 14 kann die relative Entfernung zwischen dem Taktgeber 14 und der Störung ermittelt werden. Die Störung ist dadurch auf dem Schleifring 2, 3 lokalisiert.

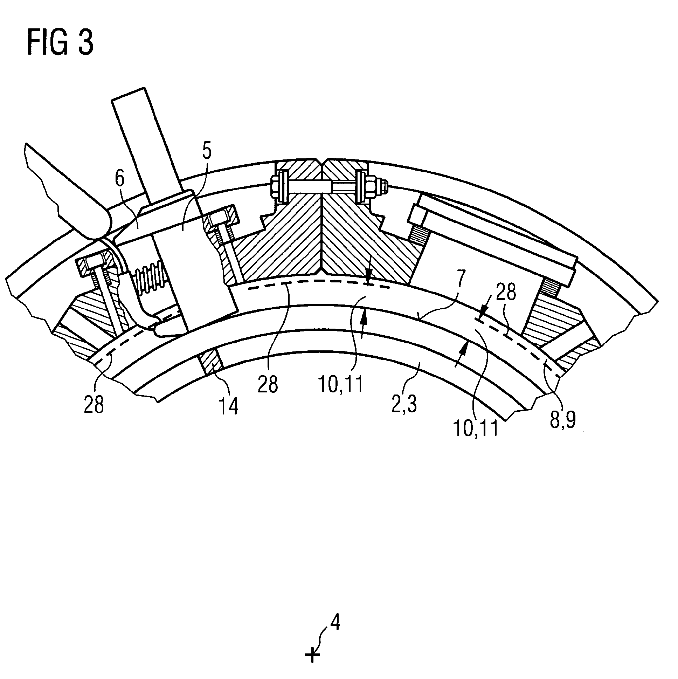

In FIG 3. ist unter anderem ein Bürstenhalter 6 dargestellt. Eine elektrische Rotationsmaschine, insbesondere ein Generator für die Energieerzeugung weist eine Vielzahl von Bürsten bzw. Bürstenhaltern auf. Zweckmäßig ist an jeder Bürstenhalterung ein Mikrofon angebracht. Der Abstand 13 zwischen einem Mikrofon 12 und einem der Schleifringe 2 oder 3 ist fest eingestellt. Der Abstand zwischen den übrigen Mikrofonen und den Schleifringen ist gleich.

Im Betrieb kann es infolge von Abnutzung, Beschädigungen oder Ähnlichem zu einem Schaden auf dem Schleifring 2, 3 kommen, das zu einem Bürstenfeuer führen kann. Durch dieses Bürstenfeuer wird ein Signal in der Antenne 8, 9 und im Mikrofon 12 erzeugt. Diese Signale werden von der Mess- und Auswerteeinrichtung 22 erfasst. In der Mess- und Auswerteeinrichtung 22 werden diese Signale derart verarbeitet und ausgewertet, dass die Möglichkeit besteht, eine Warnmeldung, Betriebsmeldung, Störmeldung oder Ähnliches zu generieren.

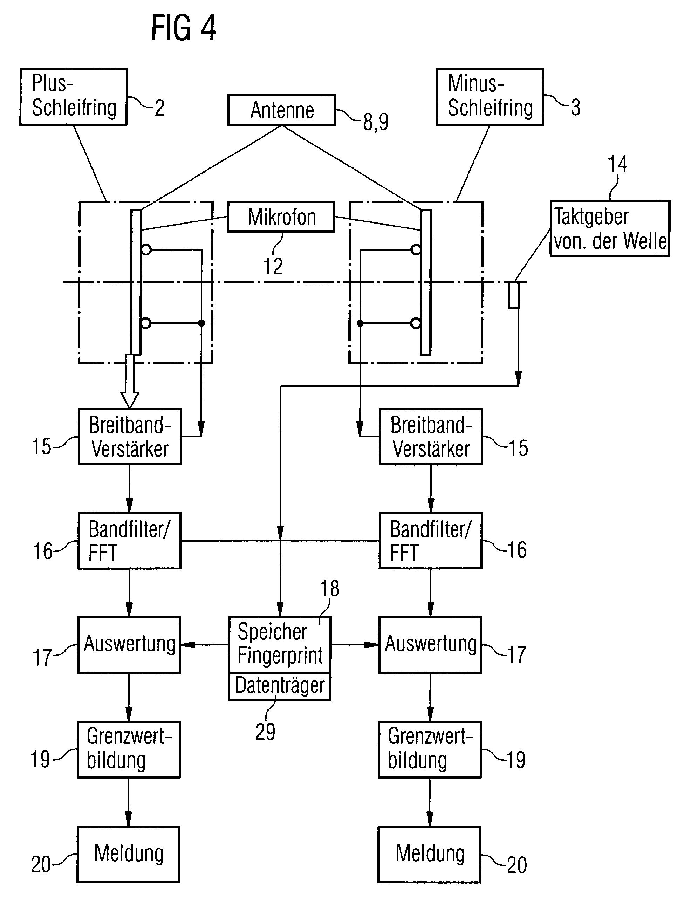

In FIG.4 ist ein vereinfachtes Blockschaltbild der Mess- und Auswerteeinrichtung 22 dargestellt. Die Informationen, die von den Antennen 8, 9 den Mikrofonen 12 erfasst werden, werden zu einem Breitbandverstärker 15 übertragen. Die im Breitbandverstärker 15 erfassten Informationen werden über einen Bandfilter 16 zu einer Auswerteeinheit 17 gebracht. Dort werden die Informationen mit Aufnahmen verglichen, die im Normalzustand aufgenommen wurden. Diese Aufnahmen sind in einem Speicher 18 im sogenannten Fingerprint hinterlegt. Nach der Auswerteeinheit 17 wird mittels einer Grenzwertbildung 19 eine Meldung 20 generiert.

Ein Vorteil der dargestellten Erregerstromzuführung ist die zeitnahe und genaue Überprüfung der Schleifringe. Die Überprüfung wurde bisher durch das Fachpersonal durch optische Kontrolle durchgeführt. Mit der Möglichkeit die erfassten Informationen von den Antennen 8,9 und den Mikrofonen in einem Datenträger 29 speichern zu können, ist ein weiterer Vorteil gegeben. Gespeicherte ältere Informationen können mit aktuellen Informationen verglichen werden. Wenn zwischen diesen Informationen eine systematische Abweichung zu erkennen ist, d.h. wenn ein Signal immer stärker oder ähnliches wird, kann eine Störung identifiziert und notwendige Maßnahmen eingeleitet werden.

### Bezugszeichenliste

- 1: Erregerstromzuführung
- 2: elektrisch negativer Schleifring
- 3: elektrisch positiver Schleifring
- 4: Rotationsachse, Drehachse
- 5: Bürste, Kohlebürsten
- 6: Bürstenhalterungen
- 7: Schleifringoberfläche
- 8: Antenne
- 9: Antenne
- 10: Abstand zwischen Antenne und Schleifring
- 11: Abstand zwischen Antenne und Schleifring
- 12: Mikrofon
- 13: Abstand zwischen Mikrofon und Schleifring
- 14: Taktgeber
- 15: Breitbandverstärker
- 16: Bandfilter
- 17: Auswerteeinheit
- 18: Speicher
- 19: Grenzwertbildung
- 20: Meldung
- 21: Welle
- 22: Mess- und Auswertesystem
- 23: Läuferwicklung
- 24: Statorwicklung
- 25: Gehäuse
- 26: Abdeckung
- 27: Turbogenerator
- 28: Antenneneinheit
- 29: Datenträger

## Patentansprüche

1. Erregerstromzuführung 1 für eine elektrische Maschine die einen auf einer Welle 21 befindlichen Schleifring 2, 3 und eine Bürste 5 aufweist, wobei die Bürste 5 in Kontakt mit dem Schleifring 2, 3 bringbar ist,
**dadurch gekennzeichnet, dass**
ein Mess- und Auswerteeinrichtung vorgesehen ist, die entlang des Schleifrings 2, 3 Antennen 8, 9 und Mikrofone 12 aufweist, um auftretende Bürstenfeuer und von Bürstenfeuer erzeugte Schäden zu detektieren.

2. Erregerstromzuführung 1 nach Anspruch 1,
**dadurch gekennzeichnet, dass**
ein Taktgeber 14 auf dem Schleifring 2, 3 angeordnet ist, zur Erzeugung eines Triggersignals, um Störungen auf dem Schleifring lokalisieren zu können.

3. Erregerstromzuführung 1 nach Anspruch 1 oder 2,
**dadurch gekennzeichnet, dass**
ein elektrisch positiver Schleifring 3 und ein elektrisch negativer Schleifring 2 mit der Mess- und Auswerteeinrichtung 22 ausgerüstet sind.

4. Erregerstromzuführung 1 nach einem der Ansprüche 1 bis 3,
**dadurch gekennzeichnet, dass**
die Antenne 8, 9 in mehrere Antenneneinheiten entlang des Schleifrings 2, 3 unterteilt ist.

5. Turbogenerator gemäß einem der Ansprüche 1 bis 4

6. Verfahren zum Messen und Auswerten von Störungen auf einem Schleifring 2, 3 einer elektrischen Maschine, bei dem eine Bürste 5 an dem Schleifring 2, 3 schleift,
**dadurch gekennzeichnet, dass** elektromagnetische Wellen, die durch Bürstenfeuer entstehen, von einer Antenne 8, 9 erfasst werden und Geräusche, die durch Schäden auf dem Schleifring 2, 3 hervorgerufen werden mit Mikrofonen 12 erfasst werden, wobei die erfassten Informationen von den elektromagnetischen Wellen und den Geräuschen mit einer Auswerteeinrichtung 22 auf einen Schaden am Schleifring 2,3 analysiert werden.

7. Verfahren nach Anspruch 6,
**dadurch gekennzeichnet, dass**
während eines belastungsfreien Betriebes der elektrischen Maschine Messergebnisse einer Messung mit der Antenne 8, 9 und den Mikrofonen 12 in einem Datenträger 29 gespeichert werden, um diese mit Messergebnissen einer Messung, die während eines belasteten Betriebes der elektrischen Maschine aufgenommen werden, vergleichen zu können.
